(19) Europäisches Patentamt / European Patent Office / Office européen des brevets

(11) **EP 4 159 621 A2**

(12) **EUROPEAN PATENT APPLICATION**

(43) Date of publication:
**05.04.2023  Bulletin 2023/14**

(21) Application number: **22193318.7**

(22) Date of filing: **31.08.2022**

(51) International Patent Classification (IPC):
**B64C 39/02** (2006.01)    **B64U 10/13** (2023.01)
**G06F 30/20** (2020.01)

(52) Cooperative Patent Classification (CPC):
**B64C 39/024; B64U 10/13; G06F 30/20;**
B64U 2201/10

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **10.09.2021  GB 202112940**

(71) Applicant: **Flare Bright Ltd**
**Westcott Buckinghamshire HP18 0XB (GB)**

(72) Inventors:
• **RIDER, Conrad**
  **Westcott, HP18 0XB (GB)**
• **HAMILTON, Kelvin**
  **Westcott, HP18 0XB (GB)**

(74) Representative: **Murgitroyd & Company**
**Murgitroyd House**
**165-169 Scotland Street**
**Glasgow G5 8PL (GB)**

(54) **DIGITAL TWIN FOR AN AUTONOMOUS VEHICLE**

(57)    The present invention relates to methods, computer program products and computing devices for calibrating a Digital Twin for an autonomous vehicle using machine learning and to the use of the calibrated Digital Twin to both tune at least one controller, navigation algorithms and/or guidance algorithms for an autonomous vehicle using machine learning and to optimising a vehicle shape of an autonomous vehicle using machine learning.

FIGURE 1

**Description**

Field of the invention

The present invention relates to a Digital Twin for an autonomous vehicle and, in particular, to the creation and calibration of the Digital Twin and the subsequent use of the Digital Twin in tuning at least one controller of the autonomous vehicle and in design optimisation of an autonomous vehicle.

Background of the invention

The traditional control system design processes for autonomous aerial drones and autonomous underwater submersibles rely on extensive operational testing and manual tuning of control parameters. This significantly limits the capability of the system to the bounds of the operational test envelope and typically requires significant operational test time which results in significant costs, time, multiple prototypes and potential damage to the autonomous vehicle during operational tests. Furthermore, manual control tuning may also present safety hazards for autonomous vehicles.

This is a major hindrance to the development of the autonomous vehicle designs, particularly where complicated control and motion physics is critical, such as for small unmanned autonomous aerial systems and unmanned autonomous underwater systems, due to the dynamic nature of the fluid through which the autonomous vehicles traverse.

Furthermore, the subsequent control of the autonomous vehicle in operation is a complex issue, in particular for autonomous vehicles as they are faced with a dynamic environment where the forces acting on the autonomous vehicle may vary significantly, for example, due to wind gusts or localised currents, during an operational deployment and from one operational deployment to another, even when performing the same operation. Moreover, as they are autonomous vehicles no human interaction or control input can be used to make any operational corrections which makes the control of the autonomous vehicle very challenging.

The present invention seeks to address, at least in part, any or all of the drawbacks and disadvantages described above.

Summary of the invention

According to a first aspect of the present invention there is provided a method of calibrating a Digital Twin for an autonomous vehicle, comprising: creating a model of the autonomous vehicle that defines one or more autonomous vehicle model parameters; defining one or more simulation scenarios, wherein each simulation scenario defines at least one test manoeuver of the autonomous vehicle; executing the one or more simulation scenarios; obtaining simulated data from one or more simulated sensors during the execution of the one or more simulation scenarios; comparing the data from one or more simulated sensors with a calibration data set, wherein the calibration data set includes data logged from one or more corresponding sensors on the autonomous vehicle during at least one real-world test manoeuver corresponding to the one or more simulation scenarios; and applying a machine learning algorithm to the comparison to calibrate the one or more autonomous vehicle model parameters of the Digital Twin.

The step of comparing may further comprise determining one or more error values based at least in part on the one or more simulated sensor data output and the data logged from the corresponding sensors on the autonomous vehicle.

Applying the machine learning algorithm may further comprise determining a calibration score based at least in part on the determined error values; and altering one or more of the autonomous vehicle model parameters prior to a subsequent execution of the one or more simulation scenarios.

Determining the calibration score may comprise applying a function to the determined error values.

Executing the one or more simulation scenarios may comprise executing one simulation scenario, executing a batch of simulation scenarios sequentially, or executing a batch of simulation scenarios concurrently.

The method may further comprise executing the one or more simulation scenarios a plurality of times until a predetermined termination criteria is met.

The method may further comprise identifying an optimal calibration of the Digital Twin as the autonomous vehicle model parameters relating to a minimised calibration score determined by the machine learning algorithm.

The method may further comprise verifying the calibrated Digital Twin, wherein verifying may comprise defining one or more second simulation scenarios, wherein each second simulation scenario defines at least one test manoeuver of the autonomous vehicle; executing the one or more second simulation scenarios using the calibrated Digital Twin; obtaining simulated data from the one or more simulated sensors during the execution of the one or more second simulation scenarios; determining one or more error values based at least in part on the one or more simulated data and a verification data set, wherein the verification data set includes data logged from one or more corresponding sensors on the autonomous vehicle during at least one real-world test manoeuver corresponding to the one or more second simulation scenarios; applying the machine learning algorithm to determine a calibration verification score based at least in part on the determined error values; and comparing the determined calibration verification score to the identified minimised calibration score, wherein if the determined calibration verification score matches, or is within a predetermined tolerance of, the minimised calibration score, the Digital Twin is sufficiently calibrated.

The calibrated Digital Twin may be used to tune one or more of at least one controller, navigation algorithms and/or guidance algorithms of the autonomous vehicle, and/or to optimise an autonomous vehicle shape.

The simulation scenarios may be executed as event-based simulations.

The machine learning algorithm may be a Bayesian Optimisation.

According to a second aspect of the present invention there is provided a computer program product comprising computer readable executable code configured to implement any one of the features of the method of the first aspect.

According to a third aspect of the present invention there is provided a computing device comprising: a memory; and at least one processor; wherein the at least one processor is configured to implement any one of the features of the method of the first aspect.

According to a fourth aspect of the present invention there is provided a method of tuning one or more of at least one controller, a navigation algorithm and/or a guidance algorithm of an autonomous vehicle, comprising: defining one or more simulation scenarios wherein each simulation scenario defines one or more components of a test manoeuver of the autonomous vehicle; defining one or more idealised control behaviours for the one or more simulation scenarios; executing the one or more simulation scenarios using a calibrated Digital Twin according to any one of the features of the method of the first aspect; obtaining one or more simulated data from the Digital Twin, wherein the obtained data represents or corresponds to one or more simulated control behaviours of the calibrated Digital Twin during the execution of the one or more simulation scenarios; comparing the one or more simulated control behaviours with the defined one or more idealised control behaviours; and applying a machine learning algorithm to the comparison to tune one or more control parameters of the at least one controller, one or more parameters of the navigation algorithm and/or one or more parameters of the guidance algorithm of the autonomous vehicle.

The step of comparing may further comprise determining one or more error values based at least in part on the simulated control behaviour and the defined idealised control behaviour.

Applying the machine learning algorithm may further comprise determining a tuning score based at least in part on the determined error values; and altering one or more of the control parameters of the at least one controller, one or more parameters of the navigation algorithm and/or one or more parameters of the guidance algorithm prior to a subsequent execution of the one or more simulation scenarios.

Determining the tuning score may comprise applying a function to the determined error values.

The control parameters may include one or more of PID parameters of a PID controller and a continuous mapping function parameters of a continuous mapping function.

The continuous mapping function may be a power function that scales the output of the PID controller; and the power function may be defined as $(v - a)^{-b}$, wherein $v$ represents a velocity of an autonomous vehicle within a fluid, $a$ represents a velocity of the autonomous vehicle within the fluid at which a scaling factor is 1, and $b$ represents the power function.

The navigation parameters may include noise covariance matrix $Q$ and $R$ values for a Kalman filter, and guidance parameters may include one or more of ascent/descent rate limits and cornering radii.

Executing the one or more simulation scenarios may comprise executing one simulation scenario, executing a batch of simulation scenarios sequentially, or executing a batch of simulation scenarios concurrently.

The method may further comprise executing the one or more simulation scenarios a plurality of times until a predetermined termination criteria is met.

The method may further comprise identifying an optimal tuning of the control parameters of the at least one controller, of the navigation parameters of the navigation algorithm, and/or of the guidance parameters of the guidance algorithm as the control parameters, the navigation parameters, and/or the guidance parameters respectively relating to a minimised tuning score determined by the machine learning algorithm.

The tuned at least one controller, the tuned navigation algorithm, and/or the tuned guidance algorithm may be implemented in an autonomous vehicle.

The method may further comprise verifying the tuned at least one controller, navigation algorithm and/or guidance algorithm, wherein verifying may comprise logging data from an autonomous vehicle, having at least one controller configured with the optimal tuning control parameters, a navigation algorithm configured with the optimal tuning navigation parameters and/or guidance algorithm configured with the optimal tuning guidance parameters, performing at least one test manoeuver that corresponds to the simulated scenario, wherein the logged data represents or corresponds to an actual control behaviour; and comparing the actual control behaviour to the idealised control behaviour, wherein if the actual control behaviour matches, or is within a predefined tolerance, of the idealised control behaviour then the at least one controller is verified.

The simulation scenarios may be executed as event-based simulations.

The machine learning algorithm may be a Bayesian Optimisation.

According to a fifth aspect of the present invention there is provided a computer program product comprising computer readable executable code configured to implement any one of the features of the method of the fourth aspect.

According to a sixth aspect of the present invention there is provided a computing device comprising: a memory; and at least one processor; wherein the at least one processor is configured to implement any one of the features of the method of the fourth aspect.

According to a seventh aspect of the present invention there is provided a method of optimising an autonomous vehicle shape, comprising: defining one or more simulation scenarios wherein each simulation scenario defines one or more manoeuvres; defining one or more idealised vehicle shape performance criteria for the one or more simulation scenarios; executing the one or more simulation scenarios using a calibrated Digital Twin according to any one of the features of the method of the first aspect; obtaining one or more simulated data from the Digital Twin, wherein the obtained data represents one or more simulated vehicle shape performance values of the calibrated Digital Twin during the execution of the one or more simulation scenarios; comparing the one or more simulated vehicle shape performance values with the defined one or more idealised vehicle shape performance criteria; and applying a machine learning algorithm to the comparison to optimise one or more vehicle shape parameters of the autonomous vehicle shape.

The step of comparing may further comprise determining one or more error values based at least in part on the simulated vehicle shape performance values and the defined idealised vehicle shape performance criteria.

Applying the machine learning algorithm may further comprise determining a design score based at least in part on the determined error values; and altering one or more of the vehicle shape parameters of the Digital Twin prior to a subsequent execution of the one or more simulation scenarios.

Determining the design score may comprise applying a function to the determined error values.

Executing the one or more simulation scenarios may comprise executing one simulation scenario, executing a batch of simulation scenarios sequentially, or executing a batch of simulation scenarios concurrently.

The method may further comprise executing the one or more simulation scenarios a plurality of times until a predetermined termination criteria is met.

The method may further comprise identifying an optimal vehicle shape as the vehicle shape parameters of the Digital Twin relating to a minimised design score determined by the machine learning algorithm.

The method may further comprise verifying the vehicle shape of the autonomous vehicle, wherein verifying may comprise: logging data from an autonomous vehicle, having a vehicle shape corresponding to the optimal vehicle shape, performing at least one test manoeuver that corresponds to the simulated scenario, wherein the logged data represents one or more actual vehicle shape performance values; and comparing the actual vehicle shape performance values to the idealised vehicle shape performance criteria, wherein if the one or more actual vehicle shape performance values matches, or is within a predefined tolerance, of the idealised vehicle shape performance criteria then the autonomous vehicle shape is optimally designed.

The method may further comprise outputting the optimised autonomous vehicle shape, such that an autonomous vehicle can be modified or manufactured based on the optimised autonomous vehicle shape.

The simulation scenarios may be executed as event-based simulations.

The machine learning algorithm may be a Bayesian Optimisation.

According to an eighth aspect of the present invention there is provided a computer program product comprising computer readable executable code configured to implement any one of the features of the method of the seventh aspect.

According to a ninth aspect of the present invention there is provided a computing device comprising: a memory; and at least one processor; wherein the at least one processor is configured to implement any one of the features of the method of the seventh aspect.

Figures

Embodiments and examples of the present invention will be described with reference to the drawings, in which:

Figure 1 shows a schematic of a system according to one or more embodiments of the present invention.

Figure 2 shows a flow chart of a calibration process for a Digital Twin according to one or more embodiments of the present invention.

Figure 3 shows a flow chart of a tuning process for a controller according to one or more embodiments of the present invention.

Figure 4 shows a flow chart of a design optimisation process for an autonomous vehicle according to one or more embodiments of the present invention.

Figure 5 is a representation of an operational envelope according to one or more embodiments of the present invention.

Figure 6 is a schematic of an autonomous nano-drone according to one or more embodiments of the present invention.

Description

The present invention relates to the calibration of a Digital Twin for an autonomous vehicle along with the subsequent use of the calibrated Digital twin for tuning at least one controller of the autonomous vehicle, for tuning the autonomous vehicle navigation algorithms and/or for tuning the autonomous vehicle guidance algorithms. The Digital Twin may also be subsequently used to optimise a design of the autonomous vehicle shape.

An autonomous vehicle, i.e. an autonomous aerial drone or an autonomous underwater submersible, refers to a vehicle that is configured to dynamically adjust, re-orientate or adapt its own course or path for at least a portion of a manoeuver, i.e. an aerial flight or an underwater voyage, without any control input from an operator or user. This may enable the autonomous vehicle to follow a pre-defined course or path based on data, such as data generated from sensors on the autonomous vehicle, where the data may indicate environmental factors, location, orientation, acceleration, velocity data or any other data collated by the autonomous vehicle in operation.

A Digital Twin may be created and calibrated for an autonomous vehicle and used in both the autonomous vehicle shape optimisation and in tuning at least one controller parameters, one or more navigation algorithm parameters and/or one or more guidance algorithm parameters of the autonomous vehicle.

The calibration of a Digital Twin corresponds to, at least in part, the automated adjustment using Machine Learning algorithms of the autonomous vehicle aerodynamic/hydrodynamic model based on comparing simulated telemetry data with actual telemetry data gathered from the real world autonomous vehicle. This has the technical effect that a Digital Twin can be created and calibrated such that the Digital Twin is an accurate digital replica of the real-world autonomous vehicle. The Digital Twin may also be used in tuning real-world controller(s) parameters, one or more navigation parameters and/or one or more guidance parameters of a real-world autonomous vehicle for use in the autonomous vehicle. The Digital Twin may also be used in optimising an autonomous vehicle shape which may subsequently be modified or manufactured to the optimised vehicle shape determined using the Digital Twin.

The tuning of at least one controller parameters, navigation algorithm parameters and/or guidance algorithm parameters relates to, at least in part, the automated adjustment using Machine Learning algorithms of the autonomous vehicle control algorithms of the at least one controller, navigation algorithm parameters and/or guidance algorithm parameters based on comparing simulated control behaviour with idealised control behaviour. This has the technical effect that the controller parameters, navigation algorithm parameters and/or guidance algorithm parameters are tuned such that the tuned controller parameters, navigation algorithm parameters and/or guidance algorithm parameters can be used on a real-world autonomous vehicle. The at least one controller parameters, navigation algorithm parameters and guidance algorithm parameters may be tuned independently, simultaneously, or in any combination.

The design optimisation of the autonomous vehicle relates to, at least in part, the automated adjustment using Machine Learning algorithms of the vehicle shape based on comparing simulated vehicle shape performance with idealised vehicle shape performance. This has the technical effect that the shape of the autonomous vehicle can be optimised such that an autonomous vehicle can be built or manufactured to the optimised vehicle shape.

Therefore, a Machine Learning (ML) process may be applied throughout the complete cycle to encompass the calibration aspects of a Digital Twin and the subsequent use of the calibrated Digital Twin in tuning at least one controller, navigation algorithms and/or guidance algorithms of the autonomous vehicle and in optimising a vehicle shape of an autonomous vehicle. This advantageously improves the cost, time and accuracy of the autonomous vehicle development. The improved process applying ML advantageously achieves a calibrated Digital Twin of the autonomous vehicle and subsequently an optimally designed and tuned autonomous vehicle, which requires less development time and without the need to perform significant real-world testing and re-testing of various autonomous vehicle prototypes.

In the embodiments and examples, a Machine Learning (ML) driven process is utilised to determine an optimally calibrated Digital Twin that is essentially a digital replica of the physical autonomous drone being developed. The ML process also enables at least one controller, a navigation algorithm and/or guidance algorithm to be tuned and optimised over a continuous spectrum of operating conditions using the calibrated Digital Twin, beyond that which can be realistically tested or designed for in a real world test, ensuring a more robust controller design, navigation algorithm and/or guidance algorithm for the autonomous vehicle. The ML process further enables a design of an autonomous vehicle to be developed, altered and tested using the calibrated Digital Twin more rapidly and cost effectively than developing multiple prototypes of the autonomous vehicle.

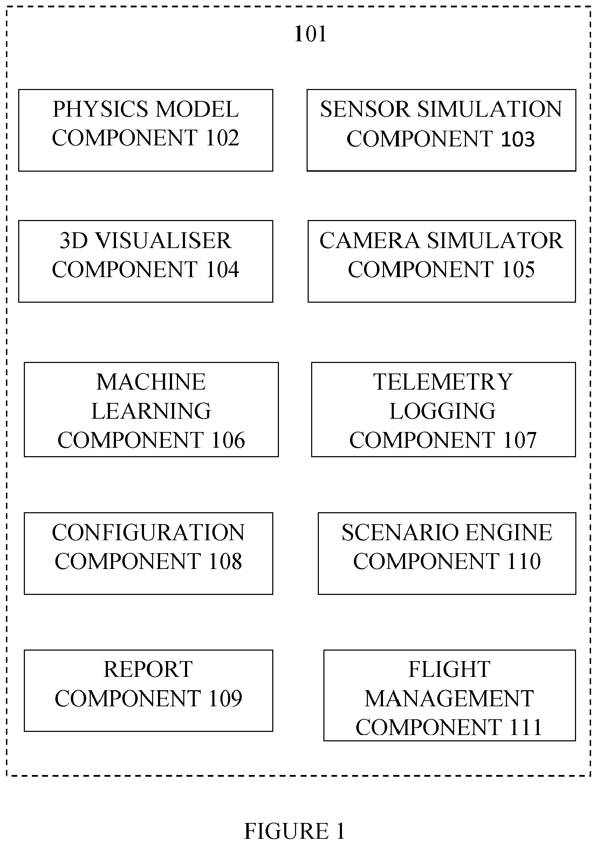

The embodiments enable the above described ML processes to utilise data from the equivalent of thousands or millions of test hours/manoeuvers which can be simulated in a fraction of the time, rather than tens or at most hundreds of hours of real-world test hours that could realistically be achieved using prototypes of the autonomous vehicle. A system for the creation and calibration of the Digital Twin along with the tuning of at least one controller parameter, at least one navigation algorithm parameter and/or guidance algorithm parameter of the autonomous vehicle and the optimisation of a vehicle shape of an autonomous vehicle, both utilising the calibrated twin based on a ML driven process is shown in Figure 1.

The system 101 may include one or more of the components described below and, as will be appreciated, any number of further components may be included in the system depending on the requirements. Furthermore, one or more components may be combined to a single component and/or be implemented by any hardware and/or software required.

The system 101, or one or more components of the system 101, may be implemented by an event-based architecture as this has several advantages. For example, an event-based architecture allows the simulation time to be effectively decoupled from actual time such that the simulations can be executed as event-based simulations and therefore based on events rather than based on time. The event-based architecture further enables the execution of simulations at any speed from slow motion to allow observation of highly dynamic behaviours, for example, launch or chaotic motion behaviour, real-time to allow observation of the simulation, through to essentially instantaneous for data gathering and for rapid calibration, tuning and design optimisation.

Furthermore, as the system may be based on an event-based architecture then if the simulations are executed essentially instantaneously the simulations may be approximately 100 times faster than real-time on a typical conventional desktop computer (for example, a desktop computer with a quad-core 2.7 GHz processor). This is advantageous as an operation (e.g. a flight or an underwater voyage) of 10 minutes in the real-world can be simulated in approximately 6 seconds, where the duration of the simulation is only limited by the computer processor capability.

However, as will be appreciated, the system 101, or one or more components, may alternatively be based on a clock-based architecture such that the simulations are executed in real-time.

The system 101 may include any number of components, for example, a physics model component 102, a sensor simulator component 103, a 3D visualiser component 104, a camera simulator component 105, a ML component 106, a telemetry logging component 107, a configuration component 108, a report component 109, a scenario engine component 110, a flight management component 111, along with any other components as required to enable the creation and calibration of the Digital Twin for the autonomous vehicle along with the tuning of at least one controller of the autonomous vehicle and the design optimisation of the autonomous vehicle.

The physics model component 102 may be based on a panel-based dynamic model that represents the vehicles, e.g. the autonomous aerial drone or autonomous underwater submersible, as a single central mass with a configurable distribution, and a user-defined collection of surfaces that capture its aerodynamic and/or hydrodynamic characteristics.

Lifting surfaces, actuators, gravity, collisions and friction all contribute to applying forces and torques to the vehicle body (e.g. the single central mass in the physics model) causing it to move and rotate, which may be suitably modelled in the physics model component 102 for the autonomous vehicle.

The physics model component 102 may be configured to simulate one or more of the physical characteristics of the autonomous vehicle or environmental effects on the autonomous vehicle. The physical characteristics may include, for example, one or more of mass, dimensions, inertial characteristics, aerodynamic/hydrodynamic characteristics such as lift, drag, pitching moments, and roll moments dependent on angle of attack and Reynolds number, collisions, friction, mechatronic characteristics such as actuator characteristics, motor characteristics and/or control surface characteristics (e.g. elevons, rudders, fins, thrusters, propellers, jets, etc.), along with any other required physical characteristic of the autonomous vehicle. The environmental effects may include, for example, one or more of gravity, air pressure, temperature, humidity, viscosity, fluid flow (including turbulence) such as wind and currents, gusts and vorticity collisions, along with any other required environmental effects on the autonomous vehicle.

The physics model component 102 may also be configured to model and/or simulate each surface of the autonomous vehicle which have configurable aerodynamic/hydrodynamic properties. For example, the physics model component 102 may be configured to model and/or simulate, for each surface of the autonomous vehicle, one or more of area, orientation, axis of movement, centre of pressure, offset from centre of mass, degradation curves caused by downwash, or other interaction, from other surfaces, along with any other required simulations for each surface of the physical model of the autonomous vehicle.

The physics model component 102 may be further configured to utilise user specified parameters and factors, for example, user-configurable lift/drag lookup tables (which may enable the use of aerodynamic data from Computational Fluid Dynamics (CFD) or wind tunnel experiments) and/or additional linear and angular drag factors.

The physics model component 102 may be a bespoke physics model software and/or hardware or may utilise one or more currently available physics model software and/or hardware tools, such as Gazebo, XPlane, JSBSim and so on. Thus, any suitable physics model software and/or hardware may be used which includes configurable parameters related to various aspects of the autonomous vehicle physical models that may be configured and/or altered by both a user and the ML component 106.

The sensor simulator component 103 may provide the functionality to simulate various sensors that may be attached, or proximate, to the autonomous vehicle with configurable noise, sensitivity, limits and latencies in order to provide a realistic view of the underlying simulation state for the sensors and for closed-loop systems.

For example, the simulated sensors may include one or more of 3-axis accelerometers, 3-axis gyroscopes, 3-axis magnetometers, barometers, depth sensors, thermistors, fluid flow sensors, and so on. However, as will be appreciated, any sensor types may be included as required depending on the autonomous vehicle being developed, the environment that the autonomous vehicle will operate in, or for any other reason.

The sensor simulator component 103 may also provide access to the raw simulation state to allow for custom in-house sensors to be implemented, or to compare simulated sensor outputs with actual corresponding sensor output on the autonomous vehicle. The sensor simulator component 103 may further provide the simulated sensor output data to one or more other components, such as the report component 109, and/or the ML component 106.

The 3D visualiser component 104 provides the user with an intuitive view of the simulated vehicle which may also include the movement of one or more actuators. The 3D visualiser component 104 may also enable user-defined meshes to be defined, and may further allow custom scene objects to be added as required. The 3D visualiser component 104 may also provide a 3D grid overlay along with a visualisation of the flight to enable a detailed inspection and a debug of the simulated flight behaviour.

The camera simulator component 105 may provide a simulated camera and may also allow for user specified ground imagery, sky boxes, fog, and underwater imagery, or any other effects as required, to be added so as to enable integration and testing of on-board computer vision algorithms in a variety of conditions.

The ML component 106 may be of an optimisation type including evolutionary learning, a reinforcement type, or any other suitable type of ML that enables the calibration of a Digital Twin along with the subsequent tuning of at least one controller of an autonomous vehicle and the design optimisation of an autonomous vehicle using the calibrated Digital Twin.

The optimisation type ML process typically include optimisation algorithms that aim to minimise, or maximise depending on the implementation, the loss or error of a training set and an example is the Bayesian Optimisation.

The reinforcement type ML process typically includes algorithms that learn in an interactive environment by trial and error and using feedback in order to maximise a total reward.

The telemetry logging component 107 logs telemetry data from sensors on, or proximate to, the autonomous vehicle during one or more test manoeuvers, e.g. test flights or test underwater voyages. The telemetry logging component 107 may log the data output by the sensors in a suitable log file format, such as a binary data file. The telemetry logging component 107 may have a predetermined, or user-defined, data frequency rate for logging the sensor output data, which may be at a different data frequency rate for different sensors and/or for different autonomous vehicles (e.g. a fast autonomous aerial vehicle may require a substantially higher data frequency rate than a slow moving autonomous underwater vehicle), such that a suitable data frequency rate is implemented to enable the calibration and tuning whilst minimising the amount of data logged and stored in the log file. The log file may be made available to the report component 109 and/or the ML component 106.

The configuration component 108 enables a user to configure one or more of the components, parameters associated with the physics model of the autonomous vehicle and/or flight or voyage algorithms. For example, the components and/or parameters that are configurable include the autonomous vehicle position and/or orientation, the application of force and/or torque, the actuation of one or more control surfaces with actual or simulated rate limits and latency, along with any other component and/or parameter of the physics model and/or autonomous vehicle model. The input may be in the form of text-based human readable configuration file, for example a Tom's Obvious Minimal Language (TOML) configuration file, however, as will be appreciated any suitable configuration file format may be used. The configuration component 108 enables the import of multiple layers of configurations for the autonomous vehicle physical model, where the configurations can range from generic configurations to specific configurations (for example, configurations specific to a particular scenario simulation for the autonomous vehicle) which may override one or more of the generic configurations.

Additionally, or alternatively, the configurations for the components and/or parameters may be stored in a database, such as a relational database, which can be input to the models from the database.

Accordingly, the configuration component 108 enables the configuration (e.g. by using one or more of configuration files, databases, or an API) of the physics model component, and/or of the flight management component.

The report component 109 may enable user configurable output of simulation data including vehicle dynamics, environmental conditions, simulated sensor data, and so on, enabling users to review and inspect simulation data outputs along with providing various configurable statistical analysis tools. The user configurable output may include Comma Separated Values (CSV) files. The report component 109 may also determine, for example as part of the statistical analysis, statistical analysis values, such as an error or differential between any simulated data and the actual real world data in the log file. The report component 109 may further determine an error or differential in relation to simulated control behaviour and the idealised control behaviour based on various simulated sensor or kinematic data along with any other required metrics to determine the error or differential. Similarly, the report component 109 may also determine an error or differential in relation to simulated vehicle shape performance and the idealised vehicle shape performance based on various simulated sensor or kinematic data along with any other required metrics to determine the required error or differential. The report component 109 may further provide programmatic access to one or more statistical analysis values or errors determined by the report component 109 via one or more Application Programming Interfaces (APIs) to the ML component 106.

The scenario engine component 110 may provide the ability to define and/or configure any number of different simulation scenarios as required and enable a user to specify any number of different validation criteria, idealised performance criteria and/or idealised behaviour for one or more individual simulation scenarios. The simulation scenarios may be specified in a scenario file which may be any suitable file type and/or format, such as a TOML file. The scenario component 110 may therefore provide a simple and effective mechanism to construct and execute the required simulations.

The simulation scenario files may also define and/or configure one or more conditions and/or parameters for each simulation scenario, for example, the simulation scenario files may include instructions and/or values to configure environmental conditions (air, wind flow, gravity, water flow, eddy currents, etc.), to configure vehicle parameters, to configure vehicle initial conditions, to verify with assertions on statistics, whether to run in slow-motion with support for "bullet-time" with normal interaction while running at 1/1000 times original speed, whether to run headless (for example, command-line only) in order to utilise the maximum CPU load, to support integration into automated tests, along with defining/configuring any other conditions and/or properties for the given simulation scenario.

The assertions may be used as part of the testing environment to determine whether the simulated autonomous vehicle behaves or performs as expected after one or more parameters of the Digital Twin physical model, the controller, and/or the design parameters are altered in-between different executions of the scenario simulations. For example, if an autonomous aerial vehicle is being simulated an assertion may include conditions defining that when the autonomous aerial vehicle is at a certain initial speed and angle then the overall flight distance of the simulation should be approximately 100m. Thus, in further simulations, if the conditions are the same but the overall flight distance is lower than the expected 100m due to one or more alterations to one or more of the parameters of the Digital Twin physical model then an error may be flagged to the user.

The simulation scenario component 110 may also be utilised to define and/or configure the autonomous vehicle control code, one or more different mission details (for example, a proposed flight or a proposed underwater voyage), during the tuning stage of the previously calibrated autonomous vehicle Digital Twin.

In terms of the autonomous aerial vehicle, simulation scenarios may include one or more of a slow speed straight flight, a slow speed roll left, a slow speed roll right, a slow speed switch roll, a slow speed switch pitch, a slow speed pitch up, a slow speed pitch down, a fast speed straight flight, a fast speed roll left, a fast speed roll right, a fast speed switch roll, a fast speed switch pitch, a fast speed pitch up, and a fast speed pitch down.

In terms of the autonomous submersible vehicle, simulation scenarios may include one or more of a slow speed straight voyage, a slow speed left turn, a slow speed right turn, a slow speed dive, a slow speed ascent, a fast speed straight voyage, a fast speed left turn, a fast speed right turn, a fast speed dive, and a fast speed ascent.

However, as will be appreciated, any number of different simulation scenarios may be constructed for execution as required for the autonomous vehicle. Furthermore, it will be appreciated that the different simulation scenarios will be specific to the function and purpose of the autonomous vehicle.

The flight management component 111 may include the software and/or firmware that defines the flight path, determines the navigation state, and controls the autonomous vehicle in operation on a flight or a voyage. The flight management component 111 may also be run within the simulation scenario engine, and/or on the autonomous vehicle itself. As will be appreciated, the term "flight" as used in the description may equally apply to an underwater voyage by an autonomous submersible vehicle.

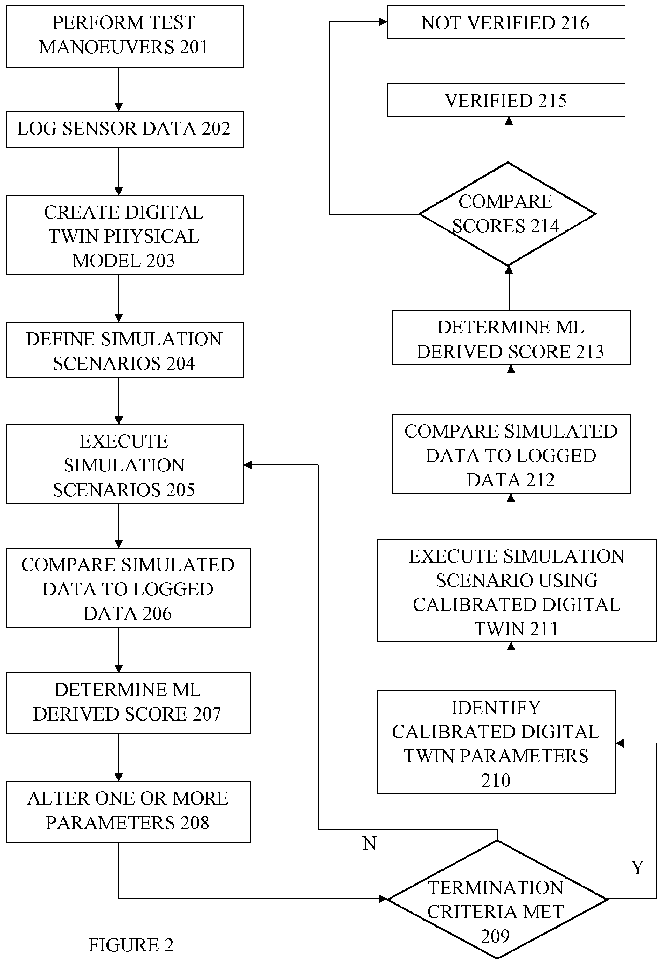

The creation and calibration of a Digital Twin using ML will now be described with reference to the flow chart shown in Figure 2.

An autonomous vehicle may be operated to perform a series of test manoeuvers 201 to gather real-world sensor data for both the calibration and the verification of the Digital Twin that is being created for the autonomous vehicle. The test manoeuvers enable telemetry data to be logged by the telemetry logger component in order to capture and log telemetry data relating to the autonomous vehicle behaviour, performance and/or sensor data during the test manoeuvers.

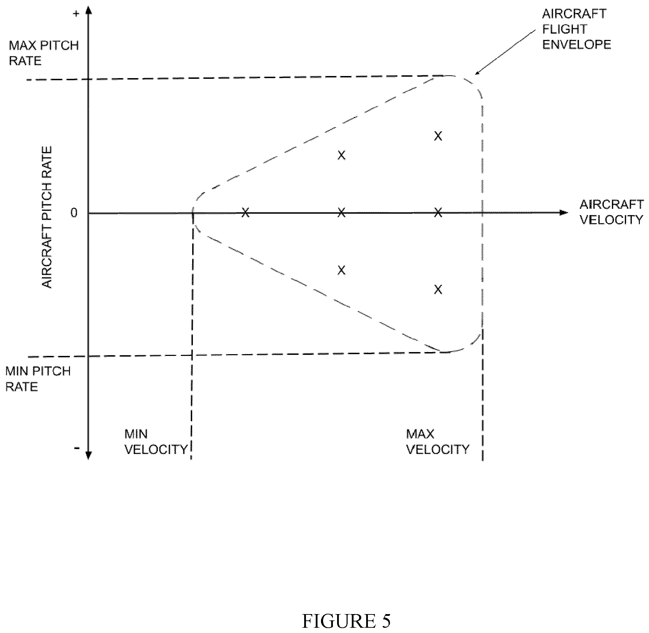

For each of the test manoeuvres performed telemetry data from sensors on, or proximate to, the autonomous vehicle will be logged 202. The test manoeuvers may be performed at one or more different speeds, one or more different pitch rates, or any individual or combinations of initial conditions that are representative of an operational envelope of the autonomous vehicle. In this example, one or more different speeds may be identified in order to be representational of an operational envelope of the autonomous vehicle. For example, if the operational envelope is narrow then a single speed may be identified that is representational of the operational envelope. If the operational envelope is wider then two or more speeds may be identified being more representational of the operational envelope and the each test manoeuver may be performed at each of the identified two or more speeds. For example, if two speeds are identified as being representational of the operational envelope of the autonomous vehicle, one speed identified may be a slow speed at, or close to, the lower boundary of the operational envelope and the second speed identified may be a fast speed at, or close to, the upper boundary of the operational envelope. A user may identify the one or more speeds, or other initial conditions, for the test manoeuvers based on the abilities of the autonomous vehicle being tested and the related operational envelope. An example operational envelope is shown in Figure 5 where the points marked with an "x" are potential speed and pitch rate combinations which may be selected to perform the test manoeuvers that are representational of the operational envelope. In the example of Figure 5, three distinct speeds and three distinct pitch rates are identified where all except two of the pitch rates at the lowest speed fall within the operation envelope and are representative thereof. As such, in the example of Figure 5, up to seven combinations of speed and pitch rate may be selected at which the test manoeuvers may be performed.

The identified initial conditions are preferably the conditions of the autonomous vehicle when initiating the test manoeuver. Two or more test manoeuvers may be performed for each manoeuvre selected so as to provide at least a first data set for the calibration of the Digital Twin and a second data set for the verification of the calibration of the Digital Twin.

The calibration and verification data sets may be logged by the telemetry logger component and may include data output from any number of sensors located on, or proximate to, the autonomous vehicle, for example, from accelerometers, gyroscopes, actuator sensors, wind sensors, pressure sensors, underwater current sensors, depth sensors, and any other suitable sensors the data from which is useful for the calibration and verification of the autonomous vehicle.

Once the calibration data set for the selected manoeuvres have been logged by the telemetry logger component, a Digital Twin physical model may be created 203 by modelling the autonomous vehicle in the physics component, thereby constructing an aerodynamic model, or a hydrodynamic model, of the autonomous vehicle that defines one or more of the mass, inertia, aerodynamic surfaces, hydrodynamic surfaces, actuators and sensors of the autonomous vehicle.

A simulation scenario may then be defined 204 in the scenario engine component for each of the selected test manoeuvers, where for each test manoeuver the scenario is defined with the same speed as used in the given test manoeuver along with any further relevant parameters relating to, or obtained from, the given test manoeuver, for example, initial conditions, limits, boundaries, latencies, and so on. The scenario may further define that the simulated sensors on the autonomous vehicle model output the simulated data at the same data rate as the actual sensors that were physically present on the autonomous vehicle in the actual test manoeuvers.

The simulation scenario corresponding to each test manoeuver may then be executed 205. The simulation scenario corresponding to each test manoeuver may be executed consecutively one after the other as a batch of simulation scenarios. However, as will be appreciated the simulation scenarios may alternatively be executed sequentially or concurrently.

After each execution of the batch of simulation scenarios 205, the output of the simulated sensors of the Digital Twin may be analysed, for example by the report component, with respect to the actual output data of the sensors on the autonomous vehicle in the calibration data set that were logged during the real-world test manoeuvers.

The analysis may include statistical and mathematical analysis which may be performed by the report component in order to compare the simulated output data of the various simulated sensors with the actual output data from the real-world sensors of the autonomous vehicle logged in the calibration data set for the batch of simulation scenarios in order to determine one or more error values. For example, the report component may determine a root-mean-square error of the simulated sensor output data with respect to the actual sensor output data from the log file of the calibration data set from the related test manoeuvers. Various other statistical and mathematical analysis may be performed by the reporting component, such as mean difference, standard deviation, centre error probable, mean absolute error, n'th root mean error, and so on, where the statistical and mathematical analysis used may be specific to the sensor or sensor data simulated and logged in the calibration data set.

The report component makes available the one or more determined error values between the simulated and actual sensor data for the plurality of sensors to the ML component, for example, via a programmatic access API.

The ML component may then apply a machine learning process to calibrate one or more parameters of the Digital Twin physical model. For example, the ML component may apply a Bayesian optimisation script in order to automatically calibrate the one or more parameters of the Digital Twin physical model.

The ML component may determine a ML derived calibration score for the batch of simulation scenarios executed. The calibration score determined by the ML component may be on any suitable scale, e.g. 0 to 1, 0 to 100, or any other scale that may be predefined. The score and scale is relevant to the ML component in order to determine an optimisation of the calibration, for example, to minimise, or maximise, the calibration score, but typically does not provide any useful information to the user. The statistical and mathematical analysis determined by the report component provides the information for the user should a detailed analysis of the data be required by the user.

The ML component may determine the calibration score for the batch of simulation scenarios, or each simulation scenario of the batch, by applying a function to the error values available from the reporting component. For example, the ML component may determine the calibration score using a weighted sum function where different weights are predefined for each of the sensors used. The weights applied for each sensor error value may be predefined based on an importance of the sensor to the design, effect on, and/or operation of the autonomous vehicle for which the Digital Twin is created.

For example, considering two sensors such as an accelerometer and a gyroscope, the report component may determine the error between the simulated output of the accelerometer and the actual output of the accelerometer from the calibration data set and further determine the error between the simulated output of the gyroscope and the actual output of the gyroscope from the calibration data set. It may be predefined that the sensor data from the gyroscope has a greater effect on the autonomous vehicle and so is weighted higher than the accelerometer. Therefore, the ML component may determine a calibration score by a weighted sum:

$$\text{calibration score} = (\text{accelerometer\_error} \times 0.2) + (\text{gyroscope\_error} \times 0.4).$$

As will be appreciated, there will be a plurality of sensors on, or proximate to, the autonomous vehicle that were both simulated and actual data logged in the calibration data set. Thus, the calibration score may be determined based on a function, e.g. weighted sum, of the error values of each of the sensors. Any other suitable function may be applied to the error values, such as a simple summation, an average, a weighted product, and so on, in order to determine the calibration score by the ML component.

Once a calibration score has been determined by the ML component it is logged and the ML component may then alter one or more of the parameters of the Digital Twin physical model 208 either sequentially or concurrently for a subsequent execution of the batch of simulation scenarios.

As will be appreciated, a physical model of the autonomous vehicle may include tens, if not hundreds, of parameters that may be configurable by the ML component and therefore a user may specify a predetermined subset of the physical model parameters that are to be calibrated for the Digital Twin by the ML component, wherein the subset of parameters are expected to have the greatest effect on the aerodynamic/hydrodynamic physical model of the given autonomous vehicle.

For example, in the case of an autonomous aerial vehicle the parameters may include one or more of overall parameters relating to the model such as overall drag factors, overall angular drag factors, parameters that control the aerodynamic lag model, along with parameters relating to a particular surface of the model, wherein the model may include any number of surfaces including wings, fins, body, elevons, such as the control of the airfoil shape, lift, drag and moment magnitudes, and control of the down-wash degradation model, along with any further parameters relating to the Digital Twin aerodynamic model as required.

In the example of the autonomous submersible vehicle the parameters may include one or more of overall parameters relating to the model such as overall drag factors, overall angular drag factors, parameters that control the hydrodynamic lag model, along with parameters relating to a particular surface of the model, wherein the model may include any number of surfaces including wings, fins, body, propellers, such as the control of the submersible shape, drag and moment magnitudes, and control of the down-wash degradation model, buoyancy, factor relating to air-sea interface interactions, along with any further parameters relating to the Digital Twin hydrodynamic model as required. Any number of Digital Twin parameters relating to the physical model of the autonomous vehicle may be simultaneously altered so as to optimally calibrate the Digital Twin.

The ML component may alter the one or more parameters in a simple manner, which is to effectively randomly alter the one or more parameters. Alternatively, the ML component may alter the one or more parameters more intelligently based on the information learnt by the ML component, for example, based on the previous ML derived scores the ML component identifies which areas of the physical model are providing the lowest scores and may focus on those areas when altering the one or more parameters.

It may then be determined whether a predefined termination criteria is met 209.

The termination criteria may be predefined by the user and may include a set number of repetitions, or if the score determined by the ML component plateaus (for example, a predefined number of calibration scores do not vary by more than a predefined threshold, e.g. 10%), or if the calibration score is below a predefined threshold which is set based on the scale used for the score.

If the predefined criteria is not met, then the batch of simulation scenarios are again executed 205 with the altered one or more parameters of the physical model of the Digital Twin.

The batch of simulation scenarios may be executed a plurality of times, for example, hundreds if not thousands of times, wherein the ML component determines a ML derived score for each execution and subsequently alters one or more parameters of the Digital Twin physical model between each execution of the batch of simulation scenarios. Thus, the process is repeated until the predefined termination criteria is met.

Once the predefined termination criteria has been met 209 the parameters of the physical model of the Digital Twin for which the ML determined calibration score is optimised, for example, the lowest ML derived calibration score, are identified as the optimal calibration parameters for the physical model of the autonomous vehicle 210.

In order to verify the calibration of the Digital Twin physical model parameters for the autonomous vehicle a second simulation scenario is defined for the same test manoeuver that corresponds to the verification data set real-world test manoeuver. A second simulation scenario is defined as between the two test manoeuvers, the first for calibration and the second for verification, one or more conditions may have changed. For example, the temperature, humidity, moments, control surfaces, and so on, may be different between the two real-world test manoeuvers. Thus, the second simulation scenario is defined to take into account any differences between the calibration real-world test manoeuver and the verification real-world test manoeuver. The second simulation scenario is then executed at least once using the calibrated Digital Twin 211. The simulated output data from the simulated sensors is analysed and compared with the actual sensor output data logged in the verification data set 212. In this regard, the report component performs the same statistical and mathematical analysis on the simulated sensor data and the actual sensor data logged in the verification data set in order to determine the respective error values. The error values are made available to the ML component, for example, via the programmatic access API and the ML component determines a calibration verification score 213 in the same manner as previously described.

If the ML component determined calibration verification score matches, or is within a predetermined tolerance of, the optimised calibration score determined during the calibration stage 214 then the Digital Twin physical model of the autonomous vehicle is verified 215. The predetermined tolerance may be any suitable tolerance, for example, a tolerance of 20% of the scale used for the score.

If the ML component determined calibration verification score for the verification data set does not match or fall within the predetermined tolerance 214 then the Digital Twin model is not verified 216 and further actions may be taken. The further actions may include a user analysing the data from the report component for the calibration and verification stages to identify any errors or problems with the simulations of the Digital Twin, redefining the physics model, and/or running the calibration process again based on the same data or based on new calibration and verification data sets.

In the above described calibration process the order in which the steps are performed may be changed and can be performed in any required order. For example, the determination of whether the termination criteria is met may be performed prior to determining an alteration to the Digital Twin parameters of the physical model for the autonomous vehicle, the creation of the Digital Twin model may be performed prior to the creation of the calibration and verification data sets, and so on.

The calibrated Digital Twin provides a technical contribution to the technical field of autonomous vehicles as it provides an accurate calibrated digital representation or digital replica of the real-world autonomous vehicle that performed the calibration and verification test manoeuvers.

The calibrated Digital Twin for the autonomous vehicle may be subsequently used to tune at least one controller, navigation algorithms and/or guidance algorithms for the actual autonomous vehicle which will be used in the real-world autonomous vehicle. The autonomous vehicle may include one or more controllers wherein one or more of the controllers may be a Proportional-Integral-Derivative (PID) controller. The one or more controllers may control the autonomous vehicle during a flight or during an underwater voyage based on various sensor input from the sensors of the autonomous vehicle and/or other data obtained or calculated that is related to the autonomous vehicle in operation. As the vehicles are autonomous then there is a significant challenge, based on the dynamic nature of the fluid and environment in which the autonomous vehicle operates, to be able to tune the controller such that it can operate as expected in the dynamic conditions without any user control.

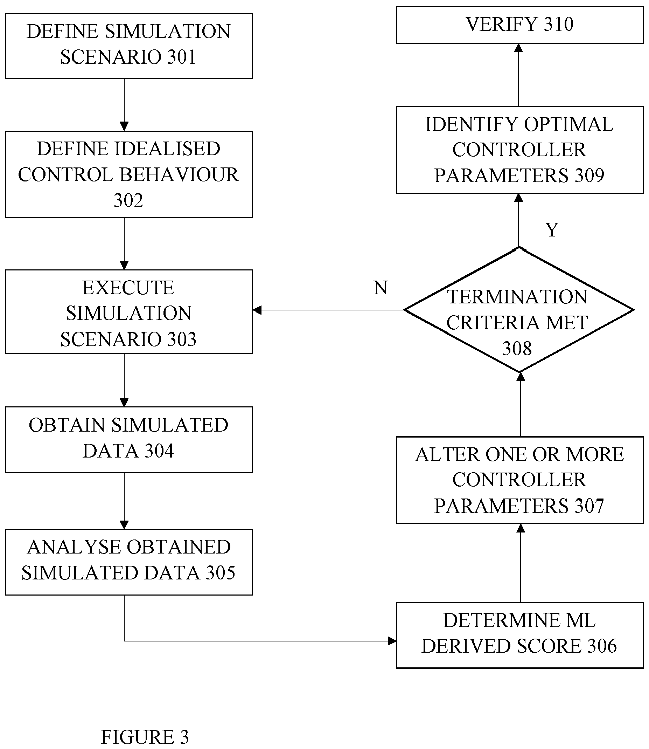

The calibrated Digital Twin is effectively a digital version of the real autonomous vehicle that reproduces the physical model of the autonomous vehicle and may be utilised for the automatic tuning of the at least one controller of the autonomous vehicle, which will now be described with reference to Figure 3.

A simulation scenario may be defined and configured in the simulation scenario component for a manoeuver that challenges the control authority of the controller 301. For example, the simulation scenario defined may include one or more components such as a specific roll angle, traversing around a corner, to hit a particular specified target position, and so on. As will be appreciated the simulation scenario will be specific to the autonomous vehicle for which the at least one controller is being tuned. The aim of the tuning simulation scenario is to define a manoeuver that utilises all of the vehicles controllers, is a challenging manoeuver, and/or representative of a manoeuver that may be required on a normal operation of the autonomous vehicle.

One or more idealised control behaviours may be defined 302 for the simulation scenario, where the idealised control behaviours define the goals of the simulation scenario that the Digital Twin should achieve. For example, the idealised control behaviour defined may include any number of goals, for example, hitting a target at a specified location, performing a particular manoeuver such as a roll, traversing around a corner, and so on. As will be appreciated any number of goals may be defined in the idealised control behaviour. The idealised control behaviour may then subsequently be compared with the simulated control behaviour as a metric to determine the optimised tuning of the at least one controller of the autonomous vehicle. The idealised control behaviour will be understood as the control behaviour that enables the autonomous vehicle to achieve the designated or predefined goals most effectively. In other words, where there is a predefined goal the ideal control behaviour is that which achieves the predefined goal. In the example of the predefined goal being to hit a target location then the ideal control behaviour may be defined as the control behaviour that achieves hitting the target 100% of the time and/or being within a predefined distance from the target 100% of the time.

The simulation scenario may then be executed 303. The simulation scenario may be executed as a single run or a batch of simulation scenarios may be executed consecutively with simulated data obtained from each simulation scenario of the batch being considered separately or aggregated together.

Simulated data relating to the simulation scenario performed by the Digital Twin may then be obtained 304. The simulated data obtained may include one or more of simulated sensor data and/or the simulated control behaviour of the Digital Twin.

The obtained simulated data may then be analysed 305, for example, by the report component, to determine one or more control response error values. The error values may relate to a difference between the idealised control behaviour and the simulated control behaviour achieved (e.g. the distance away from the target location, the difference between a requested roll angle and the simulated roll angle achieved in the simulation, and so on). This is a significant difference between the calibration of the Digital Twin and the tuning of at least one controller of the autonomous vehicle using the Digital Twin. During the calibration process the simulated sensor output was compared with actual sensor output of a real world test manoeuver whilst in the tuning process the simulated control behaviour is compared with an idealised control behaviour.

The report component may perform the analysis of the simulated data in order to determine the one or more control response error values. The simulated control behaviour may be determined based on one or more simulated data and/or simulated sensor data, for example, to determine simulated control behaviour relating to traversing a corner by an autonomous drone, the report component may utilise simulated data relating to a combination of pitch, roll, angle of attack, and so on, and/or simulated flight path data where the report component may determine a cornering radius based on simulated flight path data relating to the simulated position of the autonomous drone over time. The report component can then determine the relevant control response error values between the defined idealised control behaviour and the determined simulated control behaviour.

The report component makes available the control response error values s to the ML component, for example, via the programmatic access API, and the ML component performs an optimisation process, such as a Bayesian optimisation, that automatically tunes the PID parameters of the PID controller, in order to minimise the control response error values.

The ML component determines a tuning score 306 based on a function of the one or more control response error values determined by the report component. The function to determine a tuning score may be a weighted sum function wherein the weights applied may be determined according to expected importance of the determined control response error values. However, as will be appreciated other functions may be used to determine a tuning score value from one or more control response error values.

The scale for the tuning score determined by the ML component may be any suitable scale, e.g. 0 to 1, 1 to 100 and so on. The scale is only relevant to the ML component and is consistent throughout the multiple executions of the simulation scenario so that the ML component can minimise (or maximise depending on the implementation) the score to determine the optimal tuning for the PID controller parameters of the autonomous vehicle controller.

The PID controller parameters may then be altered 307 for each subsequent simulation scenario execution or batch of subsequent simulation scenarios being executed. The ML component may alter all of the PID controller parameters simultaneously, or may alter a subset of the PID controller parameters simultaneously, where the subset of the PID controller parameters may be predefined or be determined by the ML component, for example, based on one or more previously determined scores. The subset of the PID controller parameters may include at least two of the PID controller parameters. By altering more than one PID controller parameter simultaneously, the interrelationship between the PID controller parameters may be identified and utilised by the ML component, which would not be possible by manually altering the PID controller parameters.

The ML component may alter the PID controller parameters in a simple manner, which is to effectively randomly alter the PID controller parameters. Alternatively, the ML component may alter the PID controller parameters more intelligently based on the information learnt by the ML component, for example, based on the previous ML derived tuning scores and/or any identified interrelationship between the PID controller parameters and the control behaviour.

It may then be determined whether a predefined termination criteria is met 308.

The termination criteria may be predefined by the user and may include a set number of simulations, or if the tuning score determined by the ML component plateaus (for example, a predefined number of tuning scores do not vary by more than a predefined threshold, e.g. 10%), or if the tuning score is below a predefined threshold which may be set based on the scale used for the tuning score and/or by a user.

If the predefined criteria is not met, the simulation scenario, or batch of simulation scenarios, are executed again and the process of applying ML to determine a score and alter the PID controller parameters is repeated. Once the termination criteria has been met, the PID controller parameters for which the ML determined tuning score is minimised, for example, the lowest score, are identified as the optimal tuned PID controller parameters for the autonomous vehicle controller 309.

In order to verify 310 the tuning of the PID controller for the autonomous vehicle, the autonomous vehicle with the one or more tuned PID controller performs a test manoeuver where the test manoeuver matches the simulated manoeuver that was used to perform the tuning of the autonomous vehicle controller. Telemetry data is logged during the test manoeuver by the telemetry logging component and the actual control behaviour of the autonomous vehicle may then be compared to the idealised control behaviour.

If the actual control behaviours match, improve upon, or are within a predetermined tolerance of, the respective idealised control behaviours then the controller for the autonomous vehicle is considered to be verified and ready for operation. In other words, if the given control behaviour achieved in the real-world manoeuver is the same, similar or better than the defined respective idealised control behaviour then the controller is considered to be verified. The predetermined tolerance may be predefined and different for each control behaviour being considered. For example, if the idealised control behaviour is a goal to be within 3 metres of a target location and the simulation achieved an accuracy of 1 metre whilst the real-world manoeuver achieved an accuracy of 2 metres then even though the real-world manoeuver is not as accurate as the simulation it is still within the idealised control behaviour and so would be considered verified. A user may predefine the tolerances for each idealised control behaviour that is being tested and evaluated. It may also be useful to compare, or otherwise analyse, the actual control behaviour and the simulated control behaviour to identify any potential differences between the control behaviour achieved in the real-world and the control behaviour achieved in the simulation, which may provide useful information and analysis for the user.

In the described tuning process the order in which the steps are performed may be changed and can be performed in any required order. For example, the determination of whether the termination criteria is met may be performed prior to determining an alteration to the controller parameters, navigation parameters and/or guidance parameters for the autonomous vehicle Digital Twin.

In the above described tuning process, the optimal PID controller parameters were determined based on the ML optimisation process. In order to further improve the controller arrangement the ML component may also take into account a continuous mapping function that scales the output from the PID controller based on one or more factors, for example, environmental factors such as fluid velocity, temperature, pressure, humidity, etc., that are known to affect the controller. One such continuous mapping function is a power function which automatically scales the PID controller output and enhances the control of the autonomous vehicle. Tuning the power function manually is very challenging but the application of the ML driven tuning process enables the tuning of the power function. The power function may be defined as:

$$(v\text{-}a)^{\text{-}b},$$

wherein v represents the velocity of the autonomous vehicle within the fluid (e.g. air, water), a represents the velocity of the autonomous vehicle within the fluid at which the scaling factor is 1, and b represents the power function.

The ML component may therefore also alter the parameters a and b alongside the PID controller parameters simultaneously in order to determine the optimally tuned controller for the autonomous vehicle. A significant advantage of the use of the ML process is that the parameters of the continuous mapping function can be altered simultaneously with the controller parameters which is not possible to achieve manually, for example, the values of a and b may affect the appropriate choice for the parameter P of the PID controller such that making an alteration to a and/or b requires an alteration of P which is not typically possible to realise manually.

The simulation scenarios defined for the tuning of the at least one controller may include simulation scenarios at a plurality of speeds to improve the tuning of the PID controller parameters and the parameters a, b, of the power function.

The navigation parameters and/or the guidance parameters for the navigation and guidance algorithms respectively of the autonomous vehicle may also be tuned in a similar manner to the PID controller parameters. Thus, the tuning of the navigation parameters and/or the guidance parameters may include, in brief, defining a simulation scenario and one or more idealised control behaviours (for example, in the case of navigation algorithms the idealised control behaviour may be the defined as the configuration which results in a lowest navigation error, which may be the difference between the vehicle navigation estimate, and its actual navigation state, wherein the navigation state may refer to one or more of the position, velocity, acceleration, attitude, angular rate and angular acceleration of the vehicle), executing the simulation scenario, obtain simulated data, determine control response error values, determine an ML derived tuning score, alter the navigation parameters and/or guidance parameters, and repeat the execution of the simulation scenario determine the ML derived tuning score and alter the navigation parameters and/or guidance parameters between each execution until a predetermined termination criteria is met. The tuned navigation parameters and/or guidance parameters may then be identified as those corresponding to the lowest ML derived tuning score. The tuned navigation parameters and/or guidance parameters may then be verified based on a real-world test manoeuver corresponding to the simulation scenario. The tuning of the navigation parameters and/or guidance parameters may be performed simultaneously with the PID controller parameters or may be performed separately to the tuning of the PID controller parameters. Examples of the navigation parameters include noise covariance matrix "Q" and "R" values for a Kalman filter that fuses sensor data, however, as will be appreciated any suitable navigation parameters may be tuned. Examples of guidance parameters include ascent/descent rate limits and cornering radii, however, as will be appreciated any suitable guidance parameters may be tuned.

The controller parameters, navigation parameters and guidance parameters may be tuned separately or in any combination thereof.

The tuning of the controller parameters, the navigation parameters and/or guidance parameters provides a technical effect of effectively and efficiently tuning the controller parameters, navigation parameters and/or guidance parameters of the real-world autonomous vehicle which will be implemented on the real-world autonomous vehicle. Thus, enabling the autonomous vehicle to operate in the real world more effectively.

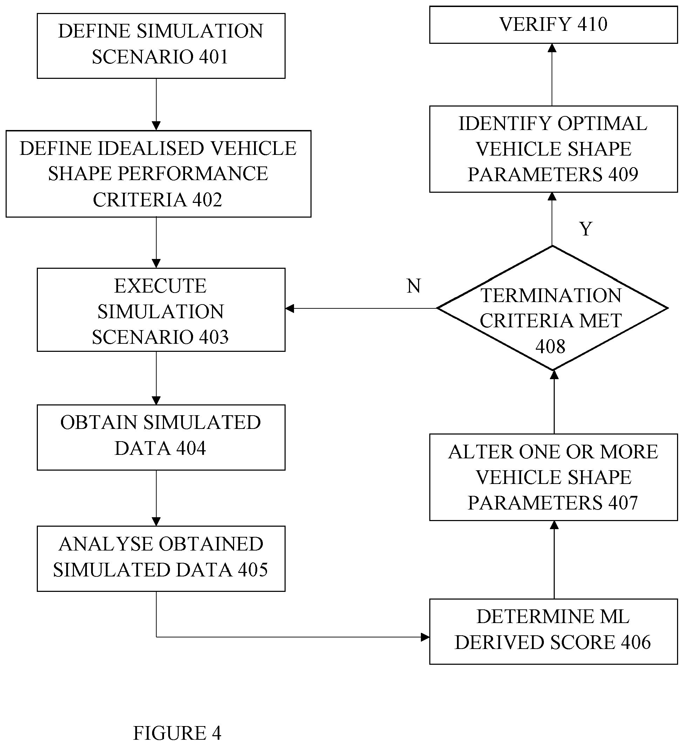

The calibrated Digital Twin may also be used along with the ML component to make automated adjustments of the vehicle shape for the autonomous vehicle based on comparing simulated vehicle shape performance with an idealised vehicle shape performance that is predefined by a user. Thus, the shape of the autonomous vehicle may be optimised, which will now be described with reference to Figure 4.

The vehicle shape refers to the shape of the outer shell of the aerial drone or underwater submersible, that is focussed on aspects or areas of the vehicle shape that may affect the aerodynamic or hydrodynamic behaviour of the autonomous vehicle.

A simulation scenario may be defined 401 to perform a particular manoeuver. The simulation scenario may define one or more parameters of the Digital Twin relevant to the simulation scenario, for example, in respect of an autonomous aerial drone the simulation scenario may define one or more control surface parameters, e.g. the elevons, to a predefined configuration and/or one or more defined surfaces with predefined parameters. As will be appreciated, the simulation scenario and the parameters defined therein will be specific to the particular manoeuver that is being defined and/or to the aspects of the vehicle shape that are to be optimised.

One or more idealised vehicle shape performance criteria may be defined 402. The idealised vehicle shape performance criteria will be understood as the vehicle shape performance that enables the autonomous vehicle to achieve the designated or predefined goals most effectively. In other words, where there is a predefined goal the ideal vehicle shape performance is that which achieves the predefined goal.

The simulation scenario is then executed 403. The simulation scenario may be executed separately or a batch of the simulation scenarios may be executed consecutively wherein the data obtained from the batch of simulation scenarios may be considered separately or aggregated together.

Simulation data may then be obtained 404, wherein the simulation data may include one or more of simulated data output from one or more simulated sensors, simulated data from one or more simulated control surfaces, for example, simulated actuators, and/or simulated kinematic data, for example, a simulated turn radius of the simulated autonomous vehicle.

The report component may then analyse the obtained simulated data 405 to determine one or more simulated vehicle shape performance values and compares the determined one or more simulated vehicle shape performance values to the corresponding idealised vehicle shape performance criteria to determine one or more vehicle shape performance error values. For example, in the simulation scenario of an autonomous aerial drone being set in a pitch-up configuration the simulated data may include the simulated pitch rate and the report component compares the simulated pitch rate with the predefined idealised pitch rate to determine an error value therebetween.

The report component makes available the one or more vehicle shape performance error values to the ML component, for example, via a programmatic access API.

The ML component may then apply a machine learning process, for example, a Bayesian optimisation, in order to optimise the shape of the autonomous vehicle, for example, the defined surfaces of the Digital Twin physical model of the vehicle shape.

The ML component may determine an ML derived design score 406 for the simulation scenario or the batch of simulation scenarios executed. The design score determined by the ML component may be on any suitable scale, e.g. 0 to 1, 0 to 100, or any other scale that may be predefined. The design score and scale is relevant to the ML component in order to determine an optimisation of the airframe design, for example, to minimise, or maximise, the design score, but typically does not provide any useful information to the user. The statistical and mathematical analysis determined by the report component provides the information for the user should a detailed analysis of the data be required by the user.

The ML component may determine the design score 406 for the simulation scenario or the batch of simulation scenarios by applying a function to the vehicle shape performance error values available from the report component. For example, the ML component may determine the design score using a weighted sum function where different weights are predefined for each of the defined control surfaces or vehicle shape surfaces. The weights applied may be predefined based on an importance of the defined control surface or vehicle shape surface to the design of the autonomous vehicle in relation to the vehicle shape performance being optimised. Other functions may be utilised by the ML component to determine the design score, such as a summation, an average, a weight product, and so on.

The ML component may then alter one or more vehicle shape parameters 407. For example, in the simulation scenario of an autonomous aerial drone being set in a pitch-up configuration the ML component may alter the vehicle shape parameters relating to a wing position, a horizontal stabiliser relative to its fuselage, along with any other parameters of the vehicle shape that may be relevant to the vehicle shape performance being evaluated. The ML component may alter the one or more vehicle shape parameters in a simple manner or a more intelligent manner as described hereinabove.

It may then be determined whether a predefined termination criteria is met 408.

The termination criteria may be predefined by the user and may include a set number of simulations, or if the design score determined by the ML component plateaus (for example, a predefined number of design scores do not vary by more than a predefined threshold, e.g. 10%), or if the design score is below a predefined threshold which is set based on the scale used for the design score.

If the predefined criteria is not met, the simulation scenario, or batch of simulation scenarios, are executed again and the process of applying ML to determine a design score and alter one or more vehicle shape parameters is repeated. Typically, the simulation scenarios will be executed thousands of times.

Once the termination criteria has been met, the vehicle shape parameters for which the ML determined design score is minimised, for example, the lowest design score, for the idealised vehicle shape performance may be identified as the optimal vehicle shape parameters for the autonomous vehicle 409.

In order to verify 410 the optimal vehicle shape parameters, the actual design of the autonomous vehicle may be modified, or a new autonomous vehicle may be manufactured based on the ML determined optimal vehicle shape parameters. The updated autonomous vehicle then performs real-world verification test manoeuvers that replicate the simulation scenarios used to optimise the design of the vehicle shape. The telemetry logging component logs data from the test manoeuvers that corresponds to the simulated data obtained or determined during the execution of the simulation scenarios. The actual vehicle shape performance error values are then determined. For example, in the test manoeuver of an autonomous aerial drone being set in a pitch-up configuration the logged data includes the actual pitch rate so that the pitch rate error can be determined, e.g. by the report component.

If the actual vehicle shape performance error values match, are an improvement on, or are within a predetermined tolerance of, the simulated vehicle shape performance error values then the design of the vehicle shape is considered to be verified. For example, in the test manoeuver of an autonomous aerial drone being set in a pitch-up configuration, the actual pitch rate error achieved in the test manoeuver is compared to the corresponding simulated pitch rate error to identify if the values match, or are within the predetermined tolerance. As will be appreciated, the predetermined tolerance may be different for different vehicle shape performance aspects being evaluated by the simulation scenario and real-world manoeuver and will be predetermined accordingly. If the vehicle shape is verified then the Digital Twin calibration process may be performed based on the new or modified vehicle shape in order to create a Digital Twin of the optimised vehicle shape.

If the vehicle shape performance error values do not match, or are outside the predetermined tolerance and therefore do not meet the requirements of the idealised vehicle shape performance then further actions may be taken. The further actions may include one or more of analysing the logged and simulated vehicle shape performance data, adjusting the idealised vehicle shape performance criteria, analyse, modify and/or perform calibration of the Digital Twin, and repeating the design optimisation process.

Alternatively or additionally, the actual vehicle shape performance may be compared to the idealised vehicle shape performance criteria and if the actual vehicle shape performance matches, or is within a predetermined tolerance of the idealised vehicle shape performance criteria then the design of the vehicle shape may be considered to be verified.

In the described optimisation process the order in which the steps are performed may be changed and can be performed in any required order. For example, the determination of whether the termination criteria is met may be performed prior to determining an alteration to the vehicle shape parameters of the Digital Twin for the autonomous vehicle.

The described optimisation process provides a technical effect as an existing autonomous vehicle shape may be modified, or a new autonomous vehicle built, based on the determined optimised vehicle shape. The optimised autonomous vehicle shape may be output, for example, to a manufacturing system, such that a real-world autonomous vehicle can be modified or can be manufactured based on the optimised autonomous vehicle shape.

Thus, the examples and embodiments of the present invention provide a new and improved process of creating a calibrated Digital Twin for an autonomous vehicle and subsequently using the calibrated Digital Twin in both tuning at least one controller, navigation algorithms and/or guidance algorithms of the autonomous vehicle and optimising the vehicle shape design. ML is applied to one or more simulated outputs and parameters in each of the processes to provide a rapid and accurate calibration, tuning and optimisation of an autonomous vehicle.

In the above described examples and embodiments any number of parameters may be altered during the ML process simultaneously and any number or type of data may be logged and simulated.

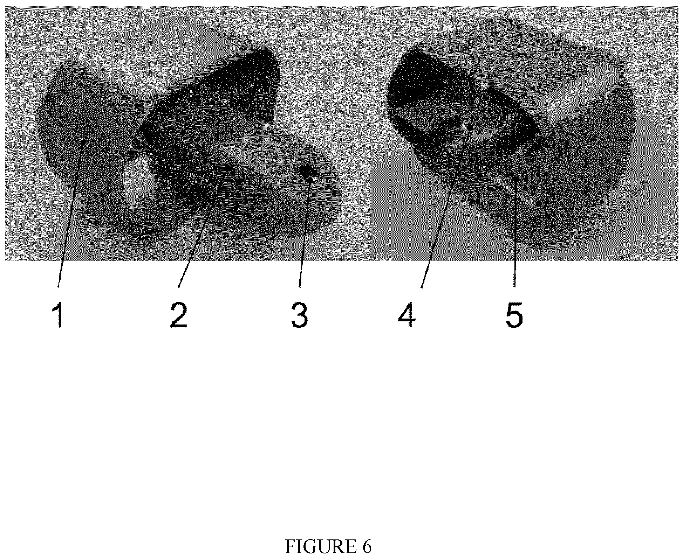

An example of the above described processes will now be described in relation to an autonomous aerial drone, in particular, to an autonomous nano-drone. The autonomous nano-drone of this example will now be described with reference to Figure 6.

The autonomous nano-drone may comprise a fixed box wing arrangement 1 that provides lift and yaw stabilisation. A main body 2 which may contain a payload for the autonomous nano-drone. Imaging capturing device 3, for example, high resolution camera, infra-red camera, and/or a low-light camera. Electrical contact plates 4 for the delivery of power and data communications to and/or from the autonomous nano-drone. Elevon control surfaces 5 which provide direct control over the pitch and roll of the autonomous nano-drone. The autonomous nano-drone may be of any suitable dimensions for the defined purpose and requirements, for example, the autonomous nano-drone shown in Figure 6 has the dimensions of 10cmx10cmx7cm. The autonomous nano-drone may include any further suitable components to enable the autonomous nano-drone to perform one or more manoeuvers, such as processors, controllers, memory, input/output devices, sensors (e.g. one or more of accelerometers, gyroscopes, magnetometers, barometers, airspeed sensors, voltage meters, current meters, laser range sensors, and so on), GPS devices, radio modems, and data/power connections, along with any components suitable for the purpose of the autonomous nano-drone, such as image capturing devices (e.g. high resolution camera, infra-red camera, and/or a low-light camera).

The autonomous nano-drone may be unpowered, that is it has no on-board propulsion means, where the initial propulsion is achieved using a launching device, however, the present invention is also applicable to an aerial drone that includes on-board propulsion means. The autonomous nano-drone has a shape that defines a plurality of control surfaces and shape surfaces. For example, control surfaces may relate to stabilisers, elevons, etc., and shape surfaces may relate to the fixed box wings including turbulators, the fore, aft, port and starboard portions of the main body, etc., along with any other part or section of the autonomous nano-drone shape that may be included as a control surface and/or a shape surface.

The creation and calibration of a Digital Twin for the autonomous nano-drone will now be described.

The autonomous nano-drone may be operated to perform a set of test flight manoeuvres in order to capture data by the telemetry logging component relating to the autonomous nano-drone flight manoeuvers. For example, the autonomous nano-drone may be operated to perform one or more of the following test manoeuvres:

- Straight.

- Roll 'left' (anticlockwise).

- Roll 'right' (clockwise).

- Roll 'switch' (for example, a repeated sequence of left then right rolls).

- Pitch up.

- Pitch down.

- Pitch 'switch' (for example, pitch down followed by pitch up).

Based on an operational envelope of the autonomous nano-drone, one or more speeds are selected at which each of the flight manoeuvres will be performed and are representational of the operational envelope. In this example, a slow launch speed and a fast launch speed that are representational of the operational envelope are selected. As the autonomous nano-drone of this example is unpowered then the speeds will relate to the launch speeds provided by the launcher. For example, a slow launch speed may be at a launch speed of approximately 25m/s and fast launch speed may be at a launch speed of approximately 40m/s. As will be appreciated, the slow launch speed and fast launch speed are specific to the design of the autonomous vehicle being operated and the launch mechanism. As such, the slow launch speed and the fast launch speed may be any suitable launch speeds appropriate to the design of the autonomous vehicle and/or the launch mechanism. Furthermore, if the autonomous vehicle was a powered vehicle, that is have on-board propulsion means, then the speeds would be dependent on speeds achievable by the propulsion means when performing the test manoeuvers and on the operational envelope of the given autonomous vehicle.

Taking the test flight manoeuver of a roll left at a slow launch speed as an example, the autonomous nano-drone is configured to fix the actuators of the autonomous nano-drone into a roll left configuration and the autonomous nano-drone is launched at the selected slow speed and at a predefined angle. In order to reduce the effects of dynamic environment conditions the test flight manoeuver is performed in controlled conditions, for example, in a building with no wind and measured air properties. The telemetry logging component then logs sensor data from all the on-board sensors including roll rate data at a suitable data rate, such as 100Hz.

Two test flights will be performed for each manoeuvre selected so as to provide a first data set for the calibration of the Digital Twin and a second data set for the verification of the calibrated Digital Twin. Therefore, the above described 7 manoeuvres are performed at the selected slow launch speed and subsequently the same 7 manoeuvres are performed at the selected fast launch speed in order to generate a calibration data set. This is repeated at least once in order to further generate a verification data set. Therefore, in this example, a total of 28 test flights are performed resulting in 14 data sets for calibration and 14 data sets for verification.

The data sets may include data output from any number of sensors located on the autonomous nano-drone, or in proximity to the autonomous nano-drone, for example, from accelerometers, gyroscopes, actuator sensors, wind sensors, pressure sensors, and any other suitable sensors the data from which is useful for the calibration and verification of the Digital Twin. The data for the data sets are collected by the telemetry logging component during the test flight manoeuvers.

Once the calibration data sets for the different manoeuvres have been gathered, a Digital Twin may be created by modelling the autonomous nano-drone in the physics component, thereby constructing an aerodynamic model of the autonomous nano-drone that defines at least the physical characteristics and aerodynamic characteristics of the autonomous nano-drone. In this example, the model of the autonomous nano-drone includes at least the mass, dimensions, surface layout, inertia, aerodynamic surfaces, control surfaces and sensors relating to the autonomous nano-drone.

A simulation scenario may then be defined in the scenario engine component for each of the 14 test flight manoeuvers, where for each test flight manoeuver the scenario is defined with the same initial conditions and parameters of the test flight manoeuvers, for example, one or more of air temperature, pressure, humidity, launch speed and moments, along with any further relevant additional parameters relating to, or obtained form, the given test flight manoeuver. The scenario may further define that the simulated sensors on the autonomous nano-drone model output at the same data rate as the actual sensors that were physically present on the autonomous nano-drone in the actual test flights.

Referring to the roll left manoeuver at a slow launch speed, the corresponding simulation scenario defines a matching manoeuver with the same slow launch speed and initial angle. The simulation scenario also defines that the simulated roll rate is to be logged at the same data rate of 100Hz.

The simulation scenarios corresponding to the test flight manoeuvers may then be executed as a batch where each of the 7 simulation scenarios are executed consecutively. The simulated data from the batch of simulation scenarios is obtained, for example, the simulated output data from the simulated sensors of the Digital Twin.

The report component then compares the simulated data to the actual data of the autonomous nano-drone that is stored in the calibration data set. The report component then performs the relevant statistical and mathematical analysis between the simulated and actual data to determine one or more error values.

Referring to the roll left at a slow launch speed simulation scenario, the report component determines a root-mean-square error, as an error value, between the simulated roll rate and the actual roll rate logged in the calibration data set.

The ML component determines a calibration score for the batch of executed simulation scenarios based on the determined one or more error values by applying a function to the determined error scores. In this example, the ML component applies a weighted sum to the error values where the weights for the different data used to determine each error value is predefined by a user based on an importance of the data to the operation of the autonomous nano-drone.

Referring to the roll left at a slow launch speed manoeuver, the root-mean-square error value is taken into account in the weighted sum in order to determine the calibration score for the batch of simulation scenarios executed.

The ML component then determines or identifies two or more parameters of the physical model of the physical model of the Digital Twin are to be altered simultaneously. The ML component may alter any or all of the parameters of the Digital Twin physical model, or a subset of parameters may be predefined by a user where the subset of parameters are expected to have the greatest effect on the aerodynamic physical model of the autonomous nano-drone for the simulation scenarios being executed. For example, the subset of parameters which may be altered simultaneously include overall drag factors, overall angular drag factors, aerodynamic lag model parameters, and one or more surface parameters of the model.

Referring to the roll left at a slow launch speed manoeuver example, at least one of the parameter of the Digital Twin model that will be altered is a roll-drag parameter.

The batch of simulation scenarios is then executed again with the altered parameters.

The ML component applies a Bayesian optimisation by determining a calibration score based on the determined error values for each of the executed batch of simulation scenarios, where the batch of simulation scenarios will be executed thousands of times and one or more parameters of the physical model of the Digital Twin are altered between each execution. The optimisation is achieved by identifying the parameters that result in the lowest calibration score.

Referring to the roll left at a slow launch speed simulation scenario, the Bayesian optimisation, based on the determined calibration scores, will minimise the root-mean-square error of the simulated roll rate compared to the actual roll rate logged in the calibration data set.

The ML optimisation continues until a termination criteria is met. In this example, the termination criteria is once the batch of simulation scenarios have been executed 5000 times, which as there are 14 simulation scenarios in this example then the total number of individual simulation scenario executions would be 70,000.

The lowest calibration score is identified and the Digital Twin parameters that achieved the lowest calibration score are also identified and considered the optimal calibrated parameters for the Digital Twin. The Digital Twin is then verified by defining a further batch of 14 simulation scenarios that include the initial conditions and parameters that correspond to the real-world validation test flight manoeuvers performed. The batch of simulation scenarios are executed and simulated data obtained. The simulated data is compared to the actual data in the verification data set by the report component and the relevant error values determined.

The ML component determines a calibration verification score by applying the weighted sum function to the error values and compares the calibration verification score to the lowest calibration score achieved in the calibration phase. If the scores match, or are within a predetermined tolerance, the Digital Twin is considered to be verified.

The Digital Twin is then utilised to tune at least one PID controller of the autonomous nano-drone, where the at least one PID controller is used to control the real-world autonomous nano-drone during operation. The autonomous nano-drone may include a plurality of PID controllers to control different control aspects of the autonomous nano-drone. The plurality of PID controllers may be tuned simultaneously.

A simulation scenario is defined in the simulation scenario component that defines a manoeuver that challenges the control authority of the one or more PID controllers, for example, the simulation scenario defined may include one or more components such as a specific roll angle, traversing around a corner, to hit a particular specified target position, and so on.

Taking the component of the simulation scenario of achieving a specific roll angle, the simulation scenario component defines a particular roll angle that the simulated Digital Twin is to achieve.

The simulation scenario further defines one or more idealised control behaviours, for example, to be within a predefined distance of the target position. In terms of the example of performing a particular roll angle the idealised control behaviour may be to be within a predetermined tolerance of the required roll angle.

The simulation scenario is then executed and simulated data is obtained, where the simulated data obtained may relate to simulated sensor output, simulated kinematic data, or any other simulated data relevant to the simulation scenario that enables a determination of the control behaviour of the Digital Twin. In terms of the example of performing a particular roll angle, the simulated data will include the simulated roll angle of the Digital Twin during the simulation execution.

The simulated data is then analysed by the report component to determine one or more error values. In terms of the example of performing a particular roll angle, one error value determined will be the difference between the simulated roll angle achieved by the Digital Twin in the simulated scenario and the requested roll angle that the Digital Twin was to perform in the simulation scenario.

The determined error values are made available to the ML component in order to optimise the PID controller parameters. The ML component determines a tuning score by applying a function, such as a weighted sum, to the error values. The PID controller parameters are then altered by the ML component prior to a subsequent execution of the simulation scenario.

The simulation scenario is executed thousands of times wherein the ML component determines a tuning score for each execution and the PID controller parameters are altered between each execution, until a predefined termination criteria is met, for example, the simulation scenario is executed 5000 times.

Once the termination criteria is met, the PID controller parameters for which the ML determined tuning score is minimised, e.g. the lowest tuning score, are identified as the optimal tuned PID controller parameters for the autonomous nano-drone. In terms of the example of performing a particular roll angle, the Bayesian optimisation will effectively tune the roll controller PID parameters by minimising the roll control error based on the minimised ML determined tuning score.

In order to verify the tuning of the PID controller for the autonomous nano-drone, the autonomous nano-drone performs a real-world verification flight manoeuver that matches the simulation scenario. During the verification flight the telemetry logging component logs data that matches the simulated data obtained from the Digital Twin during the execution of the simulation scenario. The same error values are determined by the report component and compared to the optimal simulated error values. If the error values matches, or are within a predetermined tolerance, then the PID controller parameters are considered to be verified.

In terms of the example of performing a particular roll angle, if the actual roll angle error, which is the difference between the actual roll angle achieved and the requested roll angle, is effectively 0 or within a predetermined tolerance as defined in the idealised control behaviour criteria then the PID controller parameters for the roll controller are considered to be verified.

The calibrated Digital Twin for the autonomous nano-drone may also be used to optimise the shape of the autonomous nano-drone.

A simulation scenario is defined to perform a particular manoeuver in order to optimise one or more parameters or components of the autonomous nano-drone. For example, a longitudinal position of the autonomous nano-drone box wing and a longitudinal position of the elevons relative to the autonomous nano-drone fuselage may be simultaneously analysed to determine any optimisation to these surfaces of the autonomous nano-drone shape. The optimisation of these components may be dependent on, for example, a pitch rate deficiency, which is the difference between the pitch rate achieved by the Digital Twin during the simulation and ideal maximum achievable pitch rate.

In order to optimise these surfaces of the autonomous nano-drone, a simulation scenario is defined that simulates a flight manoeuver in which the control surfaces, e.g. the elevons of the autonomous nano-drone Digital Twin are fixed into a pitch-up configuration. An idealised vehicle shape performance criteria is also defined in the simulation scenario which, in this example, is the ideal maximum achievable pitch rate.

The simulation scenario is executed and simulation data is obtained. The simulation data may include any of simulated sensor output data and/or simulated kinematic data. In this example, the simulation data includes at least the simulated pitch rate achieved by the Digital Twin during the execution of the simulation scenario.

The report component determines one or more simulated vehicle shape performance values. In this example, the report component determines the pitch rate deficiency, which is the difference between the simulated pitch rate achieved by the Digital Twin during the simulation and the ideal maximum achievable pitch rate.

The ML component determines a design score based at least on the simulated pitch rate deficiency and alters the longitudinal position of the autonomous nano-drone Digital Twin box wing as well as the longitudinal position of the elevons relative to its fuselage, such that they are altered independently of each other.

The simulation scenario is executed thousands of times wherein the ML component determines a design score for each execution and the longitudinal position of the autonomous nano-drone Digital Twin wing along with the horizontal stabiliser relative to its fuselage are altered between each execution, a until a predefined termination criteria is met, for example, the simulation scenario is executed 5000 times.

Once the termination criteria is met, the longitudinal position of the autonomous nano-drone Digital Twin box wing as well as the longitudinal position of the elevons relative to its fuselage for which the ML determined design score is minimised, e.g. the lowest design score, are identified as the optimal longitudinal position of the autonomous nano-drone Digital Twin box wing and the optimal longitudinal position of the elevons relative to its fuselage for the autonomous nano-drone. In other words, the ML Bayesian optimisation automatically configures the optimal longitudinal position of the autonomous nano-drone box wing and the longitudinal position of the elevons relative to its fuselage by substantially minimising the pitch rate deficiency.

In order to verify the optimal vehicle shape, the design of the autonomous nano-drone is adjusted to match the optimal longitudinal position of the autonomous nano-drone box wing and the longitudinal position of the elevons relative to its fuselage by modifying an existing autonomous nano-drone or manufacturing a further autonomous nano-drone to match the optimised shape.

A test manoeuver that matches the simulation scenario is performed by the updated autonomous nano-drone and the telemetry logging component logs data from the updated autonomous nano-drone. The report component determines the actual pitch rate deficiency for the updated shape of the autonomous nano-drone during the verification flight manoeuver and compares the actual pitch rate deficiency to the simulated pitch rate deficiency. If the actual pitch rate deficiency matches, or is within a predetermined tolerance of, the simulated pitch rate deficiency then the updated optimised autonomous nano-drone shape is verified.

In the foregoing embodiments, features described in relation to one embodiment may be combined, in any manner, with features of a different embodiment in order to provide a more efficient and effective calibration of a Digital Twin, tuning of at least one controller, navigation algorithms and/or guidance algorithms, and optimisation of the vehicle shape. Note that, the above description is for illustration only and other embodiments and variations may be envisaged without departing from the scope of the invention as defined by the appended claims.

**Claims**

**1.**    A method of calibrating a Digital Twin for an autonomous vehicle, comprising:

creating a model of the autonomous vehicle that defines one or more autonomous vehicle model parameters;
defining one or more simulation scenarios, wherein each simulation scenario defines at least one test manoeuver of the autonomous vehicle;
executing the one or more simulation scenarios;
obtaining simulated data from one or more simulated sensors during the execution of the one or more simulation scenarios;
comparing the data from one or more simulated sensors with a calibration data set, wherein the calibration data set includes data logged from one or more corresponding sensors on the autonomous vehicle during at least one real-world test manoeuver corresponding to the one or more simulation scenarios; and
applying a machine learning algorithm to the comparison to calibrate the one or more autonomous vehicle model parameters of the Digital Twin.

2. The method of claim 1, in which the step of comparing further comprising:
determining one or more error values based at least in part on the one or more simulated sensor data output and the data logged from the corresponding sensors on the autonomous vehicle.

3. The method of claim 2, in which applying the machine learning algorithm further comprises:

   determining a calibration score based at least in part on the determined error values; and
   altering one or more of the autonomous vehicle model parameters prior to a subsequent execution of the one or more simulation scenarios.

4. The method of claim 3, in which determining the calibration score comprises:
applying a function to the determined error values.

5. The method according to any one of the preceding claims, in which executing the one or more simulation scenarios comprises executing one simulation scenario, executing a batch of simulation scenarios sequentially, or executing a batch of simulation scenarios concurrently.

6. The method according to any one of the preceding claims, further comprising:
executing the one or more simulation scenarios a plurality of times until a predetermined termination criteria is met.

7. The method according to claim 6, further comprising:
identifying an optimal calibration of the Digital Twin as the autonomous vehicle model parameters relating to a minimised calibration score determined by the machine learning algorithm.

8. The method according to claim 7, further comprising:
verifying the calibrated Digital Twin, wherein verifying comprises:

   defining one or more second simulation scenarios, wherein each second simulation scenario defines at least one test manoeuver of the autonomous vehicle
   executing the one or more second simulation scenarios using the calibrated Digital Twin;
   obtaining simulated data from the one or more simulated sensors during the execution of the one or more second simulation scenarios;
   determining one or more error values based at least in part on the one or more simulated data and a verification data set, wherein the verification data set includes data logged from one or more corresponding sensors on the autonomous vehicle during at least one real-world test manoeuver corresponding to the one or more second simulation scenarios;
   applying the machine learning algorithm to determine a calibration verification score based at least in part on the determined error values; and
   comparing the determined calibration verification score to the identified minimised calibration score, wherein if the determined calibration verification score matches, or is within a predetermined tolerance of, the minimised calibration score, the Digital Twin is sufficiently calibrated.

9. The method according to any one of the preceding claims, in which the calibrated Digital Twin is used to tune one or more of at least one controller, navigation algorithms and/or guidance algorithms of the autonomous vehicle, and/or to optimise an autonomous vehicle shape.

10. The method according to any one of the preceding claims in which the simulation scenarios are executed as event-based simulations.

11. The method according to any one of the preceding claims in which the machine learning algorithm is a Bayesian Optimisation.

12. A computer program product comprising computer readable executable code configured to implement any one of claims 1 to 11.

13. A computing device comprising:

   a memory; and
   at least one processor; wherein the at least one processor is configured to implement any one of claims 1 to 11.

14. A method of tuning one or more of at least one controller, a navigation algorithm and/or a guidance algorithm of an autonomous vehicle, comprising:

   defining one or more simulation scenarios wherein each simulation scenario defines one or more components of a test manoeuver of the autonomous vehicle;
   defining one or more idealised control behaviours for the one or more simulation scenarios;
   executing the one or more simulation scenarios using a calibrated Digital Twin according to any one of claims 1 to 11;
   obtaining one or more simulated data from the Digital Twin, wherein the obtained data represents or corresponds to one or more simulated control behaviours of the calibrated Digital Twin during the execution of the one or more simulation scenarios;
   comparing the one or more simulated control behaviours with the defined one or more idealised control behaviours; and
   applying a machine learning algorithm to the comparison to tune one or more control parameters of the at least one controller, one or more parameters of the navigation algorithm and/or one or more parameters of the guidance algorithm of the autonomous vehicle.

15. The method of claim 14, in which the step of comparing further comprising:
   determining one or more error values based at least in part on the simulated control behaviour and the defined idealised control behaviour.

16. The method of claim 15, in which applying the machine learning algorithm further comprises:

   determining a tuning score based at least in part on the determined error values; and
   altering one or more of the control parameters of the at least one controller, one or more parameters of the navigation algorithm and/or one or more parameters of the guidance algorithm prior to a subsequent execution of the one or more simulation scenarios.

17. The method according to claim 16, in which determining the tuning score comprises:
   applying a function to the determined error values.

18. The method according to any one of claims 14 to 17, in which the control parameters include one or more of PID parameters of a PID controller and a continuous mapping function parameters of a continuous mapping function.

19. The method according to claim 18, in which the continuous mapping function is a power function that scales the output of the PID controller; and the power function is defined as $(v - a)^{A}\text{-}b$, wherein $v$ represents a velocity of an autonomous vehicle within a fluid, $a$ represents a velocity of the autonomous vehicle within the fluid at which a scaling factor is 1, and $b$ represents the power function.

20. The method according to any one of claims 14 to 19, in which the navigation parameters include noise covariance matrix Q and R values for a Kalman filter, and guidance parameters include one or more of ascent/descent rate limits and cornering radii.

21. The method according to any one of claims 14 to 20, in which executing the one or more simulation scenarios comprises executing one simulation scenario, executing a batch of simulation scenarios sequentially, or executing a batch of simulation scenarios concurrently.

22. The method according to any one of claims 14 to 21, further comprising:
   executing the one or more simulation scenarios a plurality of times until a predetermined termination criteria is met.

23. The method according to claim 22, further comprising:
   identifying an optimal tuning of the control parameters of the at least one controller, of the navigation parameters of the navigation algorithms, and/or of the guidance parameters of the guidance algorithms as the control parameters, the navigation parameters and/or the guidance parameters respectively relating to a minimised tuning score determined by the machine learning algorithm.

24. The method according to any one of claims 14 to 23, in which the tuned at least one controller, the tuned navigation algorithm and/or the tuned guidance algorithm is implemented in an autonomous vehicle.

25. The method according to claim 23, further comprising:
verifying the tuned at least one controller, navigation algorithm and/or guidance algorithm, wherein verifying comprises:

logging data from an autonomous vehicle, having at least one controller configured with the optimal tuning control parameters, a navigation algorithm configured with the optimal tuning navigation parameters and/or guidance algorithm configured with the optimal tuning guidance parameters, performing at least one test manoeuver that corresponds to the simulated scenario, wherein the logged data represents or corresponds to an actual control behaviour; and
comparing the actual control behaviour to the idealised control behaviour, wherein if the actual control behaviour matches, or is within a predefined tolerance, of the idealised control behaviour then the at least one controller is verified.

26. The method according to any one of claims 14 to 25 in which the simulation scenarios are executed as event-based simulations.

27. The method according to any one of claims 14 to 26 in which the machine learning algorithm is a Bayesian Optimisation.

28. A computer program product comprising computer readable executable code configured to implement any one of claims 14 to 27.

29. A computing device comprising:

a memory; and
at least one processor; wherein the at least one processor is configured to implement any one of claims 14 to 27.

30. A method of optimising an autonomous vehicle shape, comprising:

defining one or more simulation scenarios wherein each simulation scenario defines one or more manoeuvres;
defining one or more idealised vehicle shape performance criteria for the one or more simulation scenarios;
executing the one or more simulation scenarios using a calibrated Digital Twin according to any one of claims 1 to 11;
obtaining one or more simulated data from the Digital Twin, wherein the obtained data represents one or more simulated vehicle shape performance values of the calibrated Digital Twin during the execution of the one or more simulation scenarios;
comparing the one or more simulated vehicle shape performance values with the defined one or more idealised vehicle shape performance criteria; and
applying a machine learning algorithm to the comparison to optimise one or more vehicle shape parameters of the autonomous vehicle shape.

31. The method of claim 30, in which the step of comparing further comprising:
determining one or more error values based at least in part on the simulated vehicle shape performance values and the defined idealised vehicle shape performance criteria.

32. The method of claim 31, in which applying the machine learning algorithm further comprises:

determining a design score based at least in part on the determined error values; and
altering one or more of the vehicle shape parameters of the Digital Twin prior to a subsequent execution of the one or more simulation scenarios.

33. The method according to claim 32, in which determining the design score comprises:

applying a function to the determined error values.

**34.** The method according to any one of claims 30 to 33, in which executing the one or more simulation scenarios comprises executing one simulation scenario, executing a batch of simulation scenarios sequentially, or executing a batch of simulation scenarios concurrently.

**35.** The method according to any one of claims 30 to 34, further comprising:
executing the one or more simulation scenarios a plurality of times until a predetermined termination criteria is met.

**36.** The method according to claim 35, further comprising:
identifying an optimal vehicle shape as the vehicle shape parameters of the Digital Twin relating to a minimised design score determined by the machine learning algorithm.

**37.** The method according to claim 36, further comprising:
verifying the vehicle shape of the autonomous vehicle, wherein verifying comprises:

logging data from an autonomous vehicle, having a vehicle shape corresponding to the optimal vehicle shape, performing at least one test manoeuver that corresponds to the simulated scenario, wherein the logged data represents one or more actual vehicle shape performance values; and
comparing the actual vehicle shape performance values to the idealised vehicle shape performance criteria, wherein if the one or more actual vehicle shape performance values matches, or is within a predefined tolerance, of the idealised vehicle shape performance criteria then the autonomous vehicle shape is optimally designed.

**38.** The method according to any one of claims 30 to 37, further comprising outputting the optimised autonomous vehicle shape, such that an autonomous vehicle can be modified or manufactured based on the optimised autonomous vehicle shape.

**39.** The method according to any one of claims 30 to 38 in which the simulation scenarios are executed as event-based simulations.

**40.** The method according to any one of claims 30 to 39 in which the machine learning algorithm is a Bayesian Optimisation.

**41.** A computer program product comprising computer readable executable code configured to implement any one of claims 30 to 40.

**42.** A computing device comprising:

a memory; and
at least one processor; wherein the at least one processor is configured to implement any one of claims 30 to 40.

**101**

| | |
|---|---|
| PHYSICS MODEL COMPONENT 102 | SENSOR SIMULATION COMPONENT 103 |
| 3D VISUALISER COMPONENT 104 | CAMERA SIMULATOR COMPONENT 105 |
| MACHINE LEARNING COMPONENT 106 | TELEMETRY LOGGING COMPONENT 107 |
| CONFIGURATION COMPONENT 108 | SCENARIO ENGINE COMPONENT 110 |
| REPORT COMPONENT 109 | FLIGHT MANAGEMENT COMPONENT 111 |

FIGURE 1

PERFORM TEST
MANOEUVERS 201

LOG SENSOR DATA 202

CREATE DIGITAL
TWIN PHYSICAL
MODEL 203

DEFINE SIMULATION
SCENARIOS 204

EXECUTE
SIMULATION
SCENARIOS 205

COMPARE SIMULATED
DATA TO LOGGED
DATA 206

DETERMINE ML
DERIVED SCORE 207

ALTER ONE OR MORE
PARAMETERS 208

NOT VERIFIED 216

VERIFIED 215

COMPARE
SCORES 214

DETERMINE ML
DERIVED SCORE 213

COMPARE SIMULATED
DATA TO LOGGED
DATA 212

EXECUTE SIMULATION
SCENARIO USING
CALIBRATED DIGITAL
TWIN 211

IDENTIFY
CALIBRATED DIGITAL
TWIN PARAMETERS
210

TERMINATION
CRITERIA MET
209

N

Y

FIGURE 2

DEFINE SIMULATION
SCENARIO 301

↓

DEFINE IDEALISED
CONTROL BEHAVIOUR
302

↓

EXECUTE
SIMULATION
SCENARIO 303

↓

OBTAIN SIMULATED
DATA 304

↓

ANALYSE OBTAINED
SIMULATED DATA 305

VERIFY 310

↑

IDENTIFY OPTIMAL
CONTROLLER
PARAMETERS 309

↑ Y

N ← TERMINATION
CRITERIA MET
308

↑

ALTER ONE OR MORE
CONTROLLER
PARAMETERS 307

↑

DETERMINE ML
DERIVED SCORE 306

FIGURE 3

```
┌─────────────────────┐                              ┌─────────────────────┐
│  DEFINE SIMULATION  │                              │     VERIFY 410      │
│    SCENARIO 401     │                              └─────────────────────┘
└─────────────────────┘                                         ▲
           │                                                    │
           ▼                                         ┌─────────────────────┐
┌─────────────────────┐                              │  IDENTIFY OPTIMAL   │
│ DEFINE IDEALISED     │                             │   VEHICLE SHAPE     │
│ VEHICLE SHAPE        │                             │  PARAMETERS 409     │
│ PERFORMANCE          │                             └─────────────────────┘
│ CRITERIA 402         │                                         ▲
└─────────────────────┘                                       Y │
           │                                             ╱◇╲
           ▼                                    N    ╱           ╲
┌─────────────────────┐                       ◄─────  TERMINATION
│      EXECUTE        │                               CRITERIA MET
│    SIMULATION       │                                   408
│   SCENARIO 403      │                                  ╲         ╱
└─────────────────────┘                                    ╲◇╱
           │                                                    ▲
           ▼                                                    │
┌─────────────────────┐                              ┌─────────────────────┐
│  OBTAIN SIMULATED   │                              │  ALTER ONE OR MORE  │
│     DATA 404        │                              │   VEHICLE SHAPE     │
└─────────────────────┘                              │  PARAMETERS 407     │
           │                                         └─────────────────────┘
           ▼                                                    ▲
┌─────────────────────┐                                         │
│  ANALYSE OBTAINED   │                              ┌─────────────────────┐
│ SIMULATED DATA 405  │                              │   DETERMINE ML      │
└─────────────────────┘ ───────────────────────────►│ DERIVED SCORE 406   │
                                                     └─────────────────────┘
```

FIGURE 4

FIGURE 5

1    2    3    4    5

FIGURE 6